# EUROPEAN PATENT APPLICATION

(11) **EP 1 260 604 A1**
(43) Date of publication of application: **27.11.2002**
(21) Application number: 01901559.3
(22) Date of filing: 29.01.2001
(51) Int. Cl.: C23C 14/34, G02B 1/10, G02B 5/08

(54) **METHOD FOR PREPARING FILM OF COMPOUND MATERIAL CONTAINING GAS FORMING ELEMENT**

(30) Priority: 27.01.2000 JP 2000018145; 28.01.2000 JP 2000019480; 21.03.2000 JP 2000083285; 29.11.2000 JP 2000362262
(71) Applicant: Nikon Corporation, Tokyo 100-8331 (JP)
(72) Inventor: FURUTA, Masahiro, Nikon Corporation, Tokyo 100-8331 (JP)
(74) Representative: Wiebusch, Manfred
(86) International application number: JP0100562
(87) International publication number: WO01055477

(57) **Abstract**

A target 3, which is composed of a compound material containing a gaseous component element, is subjected to cathode discharge with a cathode 30 while closing a main valve 4 and a gas-introducing valve 9 to tightly close a vacuum chamber 1. The vacuum chamber 1 is not subjected to reduction of pressure with a vacuum pump 5 by opening the main valve 4. Therefore, the gaseous component element, which is contained in the compound material, is not discharged by the vacuum pump 5. Accordingly, almost all of the gaseous component element contained in the compound material is successfully allowed to adhere and deposit onto a substrate 2. Therefore, a thin film, which has a composition extremely close to that of the compound material, is formed on the substrate 2. According to the film formation method as described above, a compound film, which is used as a coating material for an optical element, can be formed in a desired composition on the optical element. Therefore, it is possible to obtain the optical element which has extremely high optical transmission. Such an optical element is preferably used for a projection lens of an exposure apparatus which uses a light source of a laser beam in a vacuum ultraviolet region.

## Description

### TECHNICAL FIELD

The present invention relates to a method for forming a compound film on an optical element, and a sputtering apparatus. In particular, the present invention relates to a method for forming, by means of sputtering, a film of compound material containing a gaseous component element on an optical element to be used for a light beam in a vacuum ultraviolet wavelength region of not more than 200 nm generated from an excimer laser such as ArF (193 nm) and F₂ (157 nm), and a sputtering apparatus. Further, the present invention relates to an exposure apparatus provided with the optical element to perform photolithography by using an exposure light source of a light beam in a vacuum ultraviolet wavelength region.

### BACKGROUND ART

A large number of optical elements such as lenses and reflecting mirrors are used for a semiconductor exposure apparatus. As LSI is highly integrated progressively, the wavelength of the light source of the exposure apparatus is shortened in an advanced manner from the g-ray (436 nm) to the i-ray (365 nm) and further to the excimer laser wavelength such as KrF (248 nm) and ArF (193 nm). Therefore, an optical element is required, which possesses the high transmittance and the ultraviolet light resistance in the short wavelength region as described above.

Usually, the optical element is applied with a variety of optical thin films including, for example, reflection films and antireflection films. For example, the antireflection film is applied to the surface of the optical element in order to reduce any undesirable reflection. On the other hand, the reflection film is applied to the surface of the optical element in order to effectively reflect the incoming light beam by the surface of the reflection film. A compound material such as SiN is used for such an optical thin film. The optical thin film, which is composed of the compound material as described above, can be formed on the optical element, for example, by means of the sputtering and the vacuum vapor deposition method.

However, when the compound material is composed of two types of elements having greatly different melting points, especially when the compound material contains any gaseous component element such as oxygen, nitrogen, and/or fluorine which is gas as simple substance, if the sputtering is performed by using a sputtering target of such a compound material, then a film is formed such that oxygen, nitrogen, and/or fluorine as the gaseous component element, which is included in sputtered particles flown out from the sputtering target, is omitted from the sputtered deposit. As for the composition of the formed film, the gaseous component element such as oxygen, nitrogen, and/or fluorine is deficient in view of the stoichiometric ratio. The film, in which the gaseous component element is deficient as described above, is different in physical properties from a film having a desired stoichiometric ratio. Especially, such a film does not satisfy the transmittance characteristics. Therefore, the transmittance is consequently lowered in an optical element to which such a film is applied.

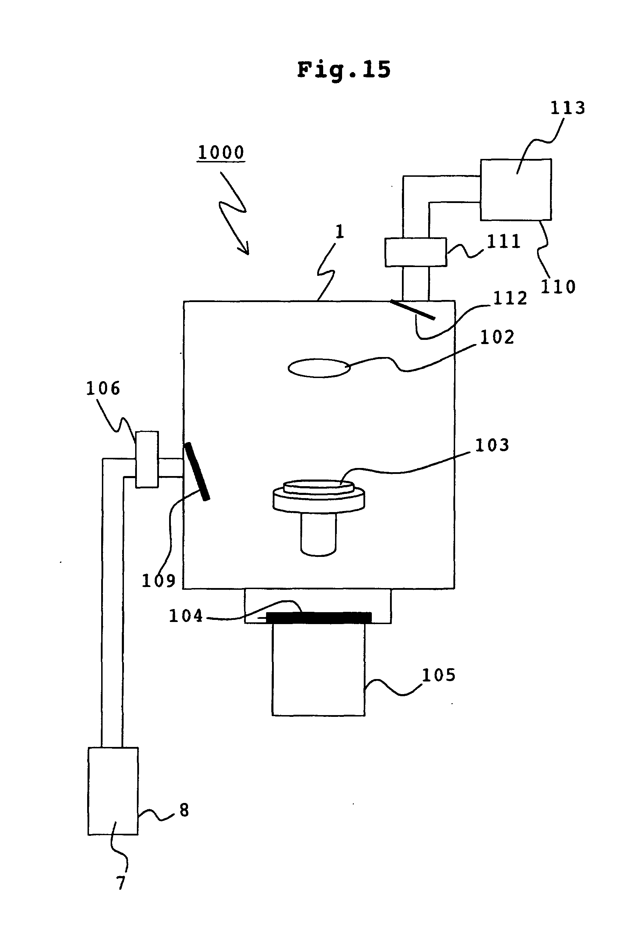

In view of the above, the sputtering has been hitherto performed while replenishing the deficient gas in order to avoid the deficiency of the gaseous component element in the formed film. A conventional sputtering apparatus and a conventional film formation method will be explained with reference to Fig. 15 for a case of the use of SiN as a compound material.

As shown in Fig. 15, the sputtering apparatus 1000 principally comprises a vacuum chamber 101, a sputtering gas bomb 108, a replenishment gas bomb 110, and a vacuum pump 105 for the discharge system. A sputtering target 103 of a compound material SiN and a substrate 102 are arranged in the vacuum chamber 101. Argon gas as sputtering gas 107 is stored in the gas bomb 108. The sputtering gas 107 flows out from the gas bomb 108, and its flow rate is adjusted by a mass flow controller 106. After that, the sputtering gas 107 passes through a gas-introducing valve 109, and it flows into the vacuum chamber 101. The replenishment gas bomb 110 is filled with nitrogen gas 113 as replenishment gas. The replenishment gas 113 flows out from the replenishment gas bomb, and its flow rate is adjusted by a mass flow controller 111. After that, the replenishment gas 113 passes through a replenishment gas-introducing valve 112, and it flows into the vacuum chamber 101. A main valve 104 is arranged between the vacuum chamber 101 and the vacuum pump 105 for the discharge system provided thereunder. When the main valve 104 is opened, the gas in the vacuum chamber 1 is discharged by the vacuum pump 105 to the outside of the vacuum chamber 101.

The film formation operation is performed as follows by using the sputtering apparatus 1000 as described above. At first, the gas-introducing valve 109 and the replenishment gas-introducing valve 112 are opened respectively to allow the argon gas 107 and the nitrogen gas 113 to flow into the vacuum chamber 101 at predetermined flow rates. Subsequently, the main valve 104 is opened to obtain a constant sputtering gas pressure in the vacuum chamber 101 while discharging the gas from the interior of the vacuum chamber. After that, an RF power source (not shown), which is connected to the vacuum chamber 101, is used to perform the cathode discharge on the sputtering target 103. Sputtered particles, which have flown out from the sputtering target 103 by the electric discharge, adhere and deposit onto the substrate 102 which functions as an anode. Thus, a thin film is formed on the substrate surface.

However, in the case of the apparatus 1000 as shown in the drawing, it is necessary to form the film while replenishing the gas. It is necessary to separately provide the gas-introducing system for introducing the replenishment gas in addition to the argon gas. That is, the apparatus 1000 requires the gas-introducing system comprising two lines. Therefore, the apparatus 1000 involves such drawbacks that the structure of the sputtering apparatus is complicated, and the cost is expensive as well. When the replenishment gas is toxic gas having extremely strong activity such as fluorine, then the careful handling operation is required, and it is also necessary to perform the operation and provide the equipment for the purpose of management.

Further, it is difficult to control the composition in the thin film in the case of the method in which the film is formed with the compound material while replenishing the gaseous component element contained in the compound material. It has been not easy to obtain a thin film having high optical transparency or transmission.

A method may be conceived, in which a film is formed with the compound material containing the gaseous component element as described above by using the vapor deposition method. However, in general, the thin film, which is obtained by the vapor deposition method, has low densification and low hardness of the film as compared with a film obtained by the sputtering method. For this reason, a problem arises such that an optical element, on which a reflection film or the like is formed by the vapor deposition method, tends to be damaged.

### DISCLOSURE OF THE INVENTION

An object of the present invention is to provide a film formation method and a sputtering apparatus which make it possible to solve the problems involved in the conventional technique described above and form a film having a desired composition with a compound material containing a gaseous component element on a substrate such as an optical element.

Another object of the present invention is to provide an optical element which is provided with a thin film having an extremely high transmittance with respect to a light beam in an ultraviolet region of not more than 300 nm, especially not more than 200 nm.

Still another object of the present invention is to provide an exposure apparatus which is provided with the optical element as described above.

According to a first aspect of the present invention, there is provided a film formation method by sputtering, comprising arranging a sputtering target composed of a compound material and a film formation objective substrate in a vacuum chamber, supplying a sputtering gas to the vacuum chamber, and then performing the sputtering in a state in which the vacuum chamber is tightly closed.

Conventionally, as shown in Fig. 15, a thin film has been formed on a substrate by effecting electric discharge for a target of a compound material while reducing the pressure in the vacuum chamber with a vacuum pump or the like. Therefore, the gaseous component element, which flies out from the compound material, is also evacuated and discharged from the interior of the vacuum chamber by the vacuum pump, for the following reason. That is, it is considered that the gaseous component element in the compound material is evacuated and discharged more frequently through a discharge valve from the vacuum chamber as compared with other components, because the gaseous component element in the compound material has a mass (atomic weight) which is smaller than those of the other components in the compound material. It is considered that even if the sputtering is performed while replenishing the gaseous component element, the gaseous component element tends to be discharged from the vacuum chamber with ease for the same reason. Therefore, it has been not easy to control the composition of the formed film.

On the other hand, the film formation method of the present invention is characterized in that the thin film is formed on the substrate (film formation objective substrate) by effecting the electric discharge for the sputtering target in the state in which the vacuum chamber is tightly closed. In the film formation method of the present invention, all of the valves are closed to allow the vacuum chamber to be in the tightly closed state after adjusting the interior of the vacuum chamber to have a predetermined pressure by supplying the sputtering gas to the vacuum chamber. When the target composed of the compound material is subjected to the electric discharge in the vacuum chamber in the tightly closed state as described above, then the gaseous component element, which is contained in the compound material, flies out from the target, and the interior of the chamber is filled with the gaseous component element. Accordingly, the gaseous component element adheres and deposits onto the substrate more frequently, and the gaseous component element is effectively used for the sputtering. Therefore, even when the compound material containing the gaseous component element is used for the target material, then the deficiency of the gaseous component element in the thin film formed on the substrate is dissolved, and thus the thin film, which has a composition extremely close to that of the target material, can be formed on the substrate.

In the case of the film formation based on the sputtering, the gas pressure in the vacuum chamber is usually controlled to have an appropriate value depending on the material of the sputtering target. In the film formation method of the present invention, the gas pressure in the tightly closed vacuum chamber can be controlled during the sputtering in accordance with the following method. For example, the temperature in the vacuum chamber may be controlled by cooling or heating the outer wall portion of the chamber, or by directly providing a heater or a cooling unit in the vacuum chamber. When it is intended to raise the pressure in the chamber during the sputtering, the temperature in the vacuum chamber may be raised in accordance with the Boyle-Charle's law or the principle of cryopump. When it is intended to lower the pressure in the vacuum chamber, the temperature in the vacuum chamber may be lowered. Accordingly, the interior of the vacuum chamber can be controlled to have a desired gas pressure, even when the gas pressure in the chamber is raised by performing the sputtering while tightly closing the interior of the vacuum chamber.

In the film formation method of the present invention, it is preferable that a distance between the target and the substrate is 15 cm to 25 cm (long throw). Accordingly, the electric discharge can be performed at a low voltage, and hence the thin film having a good quality can be formed on the substrate.

In the film formation method of the present invention, it is preferable that helicon sputtering is used for the sputtering. Accordingly, the thin film, which has high hardness, which is dense, and which has strong adhesive force, can be formed on the substrate.

In the present invention, the compound material, which is used as the target, is preferably a compound containing the gaseous component element such as oxide, nitride, or fluoride. For example, it is preferable to use SiN, MgF₂, SiO₂, Al₂O₃, AlF₃, LaF₃, and LiF. Among these materials, each of SiO₂ and Al₂O₃ has high transmission with respect to the light beam having a wavelength of 190 nm to 1000 nm, especially a wavelength in the ultraviolet region of not less than 190 nm, and each of MgF₂, AlF₃, LaF₃, and LiF has high transmission with respect to the light beam having a wavelength of 150 nm to 1000 nm, especially a wavelength in the ultraviolet region of not less than 150 nm. Therefore, such materials are preferably used for the material for an optical thin film for coating an optical element.
Especially, the compound material such as MgF₂, AlF₃, LaF₃, and LiF has high transmission or transparency with respect to the light beam in the vacuum ultraviolet wavelength region of not more than 200 nm. Therefore, such materials are extremely preferably used for the coating material for an optical element to be used for an optical system such as those for the laser lithography based on the use of the short wavelength laser.

According to a second aspect of the present invention, there is provided a film formation method for forming a thin film on a substrate by sputtering a target in a vacuum chamber, the film formation method comprising:
using at least two targets of a first target and a second target;
placing a shield plate between the first target and the substrate; and
sputtering the first target and the second target.

In the film formation method according to the second aspect of the present invention, the shield plate is allowed to intervene between the first target and the substrate, and the first target and the second target are simultaneously subjected to the electric discharge. Therefore, elements other than the gaseous component element, which are contained in the compound material for constructing the target, tend to adhere to the shield plate. The gaseous component element is apt to float in the vacuum chamber, because the mass is relatively small. Accordingly, it is possible to enhance the frequency for the gaseous component element to adhere and deposit onto the substrate, and it is possible to avoid the deficiency of the gaseous component element in the thin film. That is, the first target has the function to enrich the gaseous component element in the vacuum chamber. In the film formation method as described above, it is preferable that the substrate is arranged so that the substrate is opposed to the second target.

In the film formation method according to the second aspect of the present invention, the vacuum chamber may be tightly closed during the sputtering. Accordingly, it is possible to further increase the amount of the gaseous component element in the vacuum chamber. Therefore, it is possible to more effectively avoid the deficiency of the gaseous component element in the thin film formed on the substrate.

The first target and the second target may be formed of a compound material containing at least one common element, for example, a gaseous component element. The first and second targets may be formed of an identical compound material. When each of the first and second targets contains the gaseous component element, it is preferable that the compound material for the first target contains the gaseous component element in an amount larger than that of the second target. Accordingly, it is possible to supply a large amount of the gaseous component element during the sputtering. It is possible to avoid the deficiency of the gaseous component element in the thin film formed on the substrate.

In the second film formation method of the present invention, the following procedure may be also available. That is, for example, a first electric power is applied to the first cathode electrode to sputter the first target, and a second electric power, which is different from the first electric power, is applied to the second target to sputter the second target. When the different electric powers are supplied to the first target and the second target, then it is possible to control the amounts of sputtered particles released from the first target and the second target respectively, and it is possible to control the composition of the thin film formed on the substrate. When the electric power is controlled so that the gaseous component element is released in a large amount from the first target which is covered with the shield plate, it is possible to control the amount of the gaseous component element in the chamber. Therefore, it is possible to avoid the deficiency of the gaseous component element in the thin film formed on the substrate.

In the film formation method of the present invention, the sputtering can be performed while revolving the substrate so that the substrate alternately passes across positions just over the first target and the second target respectively. Accordingly, the gaseous component element tends to adhere and deposit when the substrate passes over the first target. Therefore, it is possible to avoid the deficiency of the gaseous component element in the thin film formed on the substrate. It is preferable that the velocity of revolution is determined so that the gaseous component element in the thin film formed on the substrate exists uniformly.

Alternatively, the substrate may be arranged so that the substrate is opposed to any one of the first target and the second target, and the sputtering may be performed while rotating the first target and the second target with respect to the substrate.

According to a third aspect of the present invention, there is provided a film formation method for forming a thin film on a substrate by sputtering a target in a vacuum chamber, the film formation method comprising:
independently controlling temperatures of the substrate, the target, and interior of the vacuum chamber.

In the film formation method according to the third aspect of the present invention, it is preferable that at least one temperature of the temperature of the substrate and the temperature of the target is controlled so that the temperature of the substrate is lower than the temperature of the target. Further, it is preferable that at least one temperature of the temperature of the substrate and the temperature of the interior of the vacuum chamber is controlled so that the temperature of the substrate is lower than the temperature of the interior of the vacuum chamber. When the temperature of the substrate is made lower than the temperature of the target or the temperature of the interior of the chamber, then the gaseous component element, which is released from the compound material by the sputtering, tends to adhere and deposit onto the substrate, and it is possible to avoid the deficiency of the gaseous component element in the thin film formed on the substrate.

In the film formation method according to any one of the first to third aspects of the present invention, for example, Ar gas, Xe gas, He gas, SF₆ gas, or mixed gas of Ar and SF₆ may be used for the sputtering gas. For example, when MgF₂ is used as the compound material, it is preferable to use SF₆ gas or mixed gas of Ar-SF₆.

According to a fourth aspect of the present invention, there is provided a sputtering apparatus for forming a thin film on a substrate, the sputtering apparatus comprising:
a vacuum chamber;
a gas-introducing valve which is formed for the vacuum chamber and which is used to introduce a sputtering gas into the vacuum chamber;
a gas discharge valve which is formed for the vacuum chamber and which is used to discharge the sputtering gas from interior of the vacuum chamber; and
a control unit which controls the gas-introducing valve and the gas discharge valve to be closed during sputtering so that the vacuum chamber is tightly closed.

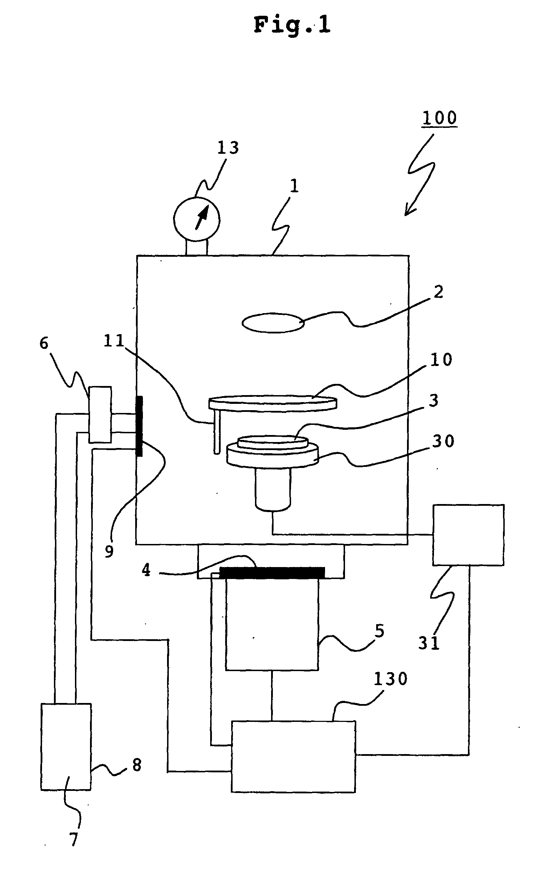

In the sputtering apparatus according to the fourth aspect of the present invention, the control unit controls the valves as follows over the entire period or for a certain period of the cathode discharge. That is, as shown in Fig. 1, the gas-introducing valve 9, which is provided to introduce the sputtering gas 7 into the vacuum chamber 1, is closed, and the main valve 4, which is provided to discharge the gas from the interior of the vacuum chamber 1, is closed. That is, the interior of the vacuum chamber 1 is tightly closed during the film formation. Therefore, the sputtered particles, which are generated by the electric discharge, are not evacuated and discharged to the outside of the vacuum chamber. Therefore, the sputtered particles exist in a large ratio in the vacuum chamber 1, and a large number of sputtered particles contribute to the film formation. In the case of the sputtering apparatus as described above, even when the compound material, which contains the gaseous component element, is used for the target material, the thin film having a desired composition, in which the deficiency of the gaseous component element is reduced, can be formed on the substrate. The sputtering apparatus of this aspect is preferably used for the film formation method according to the first aspect of the present invention.

The sputtering apparatus according to the fourth aspect of the present invention may further comprise a pressure control unit which controls an internal pressure of the vacuum chamber. The pressure control unit as described above may be a temperature-adjusting unit which adjusts an internal temperature of the vacuum chamber. The temperature-adjusting unit may be constructed, for example, with a tube which is helically arranged on the outer wall portion of the vacuum chamber, and a temperature-regulating fluid supply unit which allows a fluid (temperature-regulating fluid) having an adjusted temperature to flow through the tube. For example, water or nonfreezing fluid can be used for the temperature-regulating fluid. A Peltier element may be also used for the temperature-regulating unit. When the temperature in the vacuum chamber is controlled by using the temperature-adjusting unit as described above, the pressure in the tightly closed vacuum chamber can be maintained to be an optimum pressure during the film formation.

According to a fifth aspect of the present invention, there is provided a sputtering apparatus for forming a thin film on a substrate, comprising:
a vacuum chamber;
a first cathode electrode which is provided in the vacuum chamber and on which a first target is placed;
a second cathode electrode which is juxtaposed with the first cathode electrode in the vacuum chamber and on which a second target is placed;
a power source which supplies electric power to the first cathode electrode and the second cathode electrode; and
a shield plate which is positioned between the first cathode electrode and the substrate, wherein:
   the electric power is supplied from the power source to the first cathode electrode and the second cathode electrode to perform sputtering while shielding the first cathode electrode with the shield plate.

The sputtering apparatus according to the fifth aspect of the present invention is preferably used to carry out the film formation method according to the second aspect of the present invention. In this sputtering apparatus, the two targets are subjected to the electric discharge by using the two cathode electrodes. Therefore, the sputtering apparatus is also advantageous in that a steady state can be quickly established in the vacuum chamber. The sputtering apparatus comprises the two cathode electrodes of the first cathode electrode and the second cathode electrode, and the sputtering apparatus further comprises the shield plate disposed between the first cathode electrode and the substrate. It is preferable that the shield plate has such a dimension that the entire upper surface of the target arranged on the cathode electrode is covered therewith. The spacing distance between the shield plate and the target is arbitrary, which may be, for example, 1 to 2 cm. The shield plate avoids the adhesion, to the substrate, of the sputtered particles flown from the target on the first cathode electrode. When the compound material containing the gaseous component element is used for the target material, then the sputtered particles of those other than the gaseous component element in the compound material of the first target adhere to the shield plate, and the gaseous component element floats in the vacuum chamber. Therefore, it is possible to increase the amount of the gaseous component element in the vacuum chamber as compared with a case in which only the second target is subjected to the electric discharge. Thus, it is possible to avoid the deficiency of the gaseous component element in the thin film formed on the substrate. In the case of the arrangement as described above, it is preferable that the substrate is arranged so that the substrate is opposed to the second target. Accordingly, it is possible to facilitate the deposition of the sputtered particles from the second target on the substrate. The shield plate may be fixed, or the shield plate may be an openable/closable shutter. However, in the present invention, it is necessary to shield the first target during the period in which the electric power is supplied to the first cathode electrode.

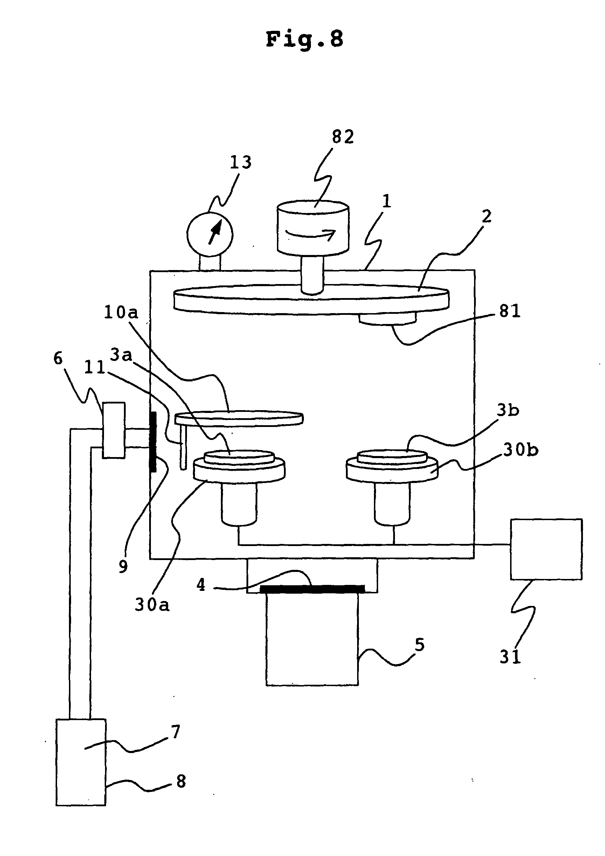

The sputtering apparatus according to the fifth aspect of the present invention may further comprise a rotatable substrate holder 81 for holding a substrate 2 as shown in Fig. 8. The substrate holder 81 is driven and rotated by a motor 82. The substrate 2 is provided eccentrically with respect to the axis of rotation of the substrate holder 81. Accordingly, the substrate 2 alternately passes across the positions just over the two targets arranged in the vacuum chamber 1. When the substrate 2 passes across the position just over the second target 3b, the sputtered particles in the second target material adhere to the substrate. When the substrate 2 passes across the position just over the first target 3a covered with the shield plate 10a, then the gaseous component element in the first target material tends to adhere, and the other elements adhere to the shield plate 10a. Therefore, it is possible to more effectively replenish the gaseous component element to the thin film to be formed on the substrate by performing the film formation while rotating the substrate with the substrate holder. A plurality of substrate can be also attached to the substrate holder.

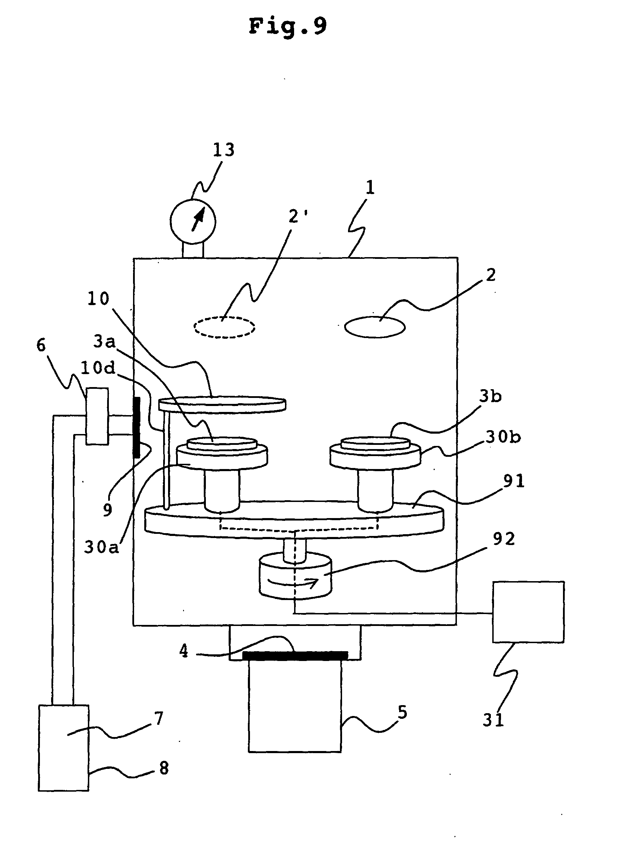

Alternatively, for example, as shown in Fig. 9, the sputtering apparatus of the present invention may comprise a rotary stand 91 which revolves the first cathode electrode 30a and the second cathode electrode 30b with respect to the substrate 2. The rotary stand 91 can be driven and rotated by using a motor 92. A support rod 10d for supporting the shield plate 10 provided over the first cathode electrode 30a is fixed to the rotary stand 91. In this case, it is preferable that the substrate 2 is arranged on the axis eccentric to the axis of rotation of the rotary stand 91 and on the orbit of rotation of the first cathode and the second cathode. Accordingly, when the rotary stand is rotated, the first target 3a and the second target 3b, which are placed on the first cathode electrode 30a and the second cathode electrode 30b respectively, can be allowed to pass alternately across the substrate 2. When the second target 3b is opposed to the substrate 2 in accordance with the rotation of the rotary stand 91, the second target material is formed as a film on the substrate 2. When the first target 3a is opposed to the substrate 2, the adhesion is facilitated for the gaseous component element in the first target material. Accordingly, it is possible to avoid the shortage of the gaseous component element in the thin film formed on the substrate. Further, a plurality of substrates may be installed. For example, as shown in Fig. 9, a substrate 2' may be arranged.

The electric power, which is supplied to the first cathode electrode by the power source of the sputtering apparatus of the present invention, may be different from the electric power which is supplied to the second cathode electrode. The amount of particles released from the target material is proportional to the electric power supplied to the cathode. Therefore, for example, when the electric power is supplied from the power source such that the electric power, which is supplied to the first cathode electrode to place the first target covered with the shield plate, is higher than the electric power which is supplied to the second cathode electrode, it is possible to release a large amount of the gaseous component element from the target disposed on the first cathode electrode.

The sputtering apparatus of the present invention may comprise a coil which is disposed at least one position over the first cathode electrode and the second cathode electrode and which generates a helicon wave. Especially, it is preferable to provide the coil over the first cathode electrode.

In the sputtering apparatus of the present invention, it is preferable that each of a distance between the substrate and the first target placed on the first cathode electrode and a distance between the substrate and the second target placed on the second cathode electrode is within a range of 15 cm to 25 cm (long throw). When the distance between the substrate and the target is within the range as described above, then the target is subjected to the electric discharge at a low voltage, and the film quality of the thin film formed on the substrate is made uniform.

In the sputtering apparatus according to the fifth aspect of the present invention, it is preferable that the first target and the second target are formed of compound materials containing at least one common element. It is preferable that the first target is formed of the compound material which releases a large amount of gaseous component element during the sputtering. For example, when MgF₂ is used for the second target, AlF₃ can be used for the first target material. When SiN(SiₓN₁₋ₓ) is used for the second target, SiₓN₁₋ₓ containing a larger amount of N component can be used for the first target material. Accordingly, it is possible to replenish a large amount of gaseous component element to the thin film. The first and second targets may be formed of an identical compound material.

According to a sixth aspect of the present invention, there is provided a sputtering apparatus for forming a thin film on a substrate, the sputtering apparatus comprising:
a vacuum chamber;
a cathode electrode which is arranged in the vacuum chamber and on which a target is placed;
a vacuum chamber temperature-regulating unit which regulates temperature in the vacuum chamber;
a target temperature-regulating unit which regulates temperature of the target; and
a substrate temperature-regulating unit which regulates temperature of the substrate.

The sputtering apparatus according to the sixth aspect of the present invention is preferably used to carry out the film formation method according to the third aspect of the present invention. This sputtering apparatus may further comprise a control unit which controls the chamber temperature-regulating unit, the target temperature-regulating unit, and the substrate temperature-regulating unit. The control unit may control at least one of the chamber temperature-regulating unit and the substrate temperature-regulating unit so that the temperature of the substrate is lower than the temperature in the vacuum chamber. Further, the control unit may also control at least one of the target temperature-regulating unit and the substrate temperature-regulating unit so that the temperature of the substrate is lower than the temperature of the target. When the substrate, which is the film formation objective substrate, has the temperature lower than the temperature of the target or the temperature of the vacuum chamber, the gaseous component element tends to adhere and deposit onto the substrate. When the sputtering apparatus as described above is used, it is possible to form the compound thin film having a desired composition in which the deficiency of the gaseous component element is avoided.

In the present invention, an optical element such as a lens, a prism, or a reflecting mirror may be used for the substrate.

According to a seventh aspect of the present invention, there is provided an optical element having a thin film which is formed by the film formation method according to any one of the first to third aspects of the present invention. Such a optical element has high transmission or transparency with respect to a light beam having a wavelength of 150 nm to 1000 nm, especially when a fluorine-based compound material is used. Therefore, the optical element is most appropriately used for the optical system for the laser lithography based on the use of a short wavelength laser, especially an excimer laser. The thin film, which is formed on the optical element, is a densified thin film in which the adhesive force is strong and the hardness is high, as compared with a thin film formed by means of the vacuum evaporation method, because the thin film is formed by means of the sputtering method. The optical element of the present invention coated with the thin film as described above is scarcely scratched, and it can be handled with ease. Thus, the optical element makes it easy to assemble and adjust the optical system.

According to an eighth aspect of the present invention, there is provided an exposure apparatus for exposing a substrate with an image of a pattern on a mask, the exposure apparatus comprising:
an illumination optical system which illuminates the mask with a vacuum ultraviolet light beam; and
a projection optical system which includes the optical element according to the seventh aspect of the present invention and which projects the image of the pattern on the mask onto the substrate.

According to a ninth aspect of the present invention, there is provided an exposure apparatus for exposing a substrate with an image of a pattern on a mask, the exposure apparatus comprising:
an illumination optical system which includes the optical element according to the seventh aspect of the present invention and which illuminates the mask with a vacuum ultraviolet light beam; and
a projection optical system which projects the image of the pattern on the mask onto the substrate.

The exposure apparatus of the present invention comprises the optical element according to the seventh aspect of the present invention having the high optical transmission, for at least one of the illumination optical system and the projection optical system. Therefore, it is possible to reduce the loss of the exposure light beam as compared with a conventional exposure apparatus. Further, it is possible to maintain the optical characteristics of the projection optical system and/or the illumination optical system including, for example, the focus, the distortion, the telecentricity, and the illuminance in a well-suited manner.

### BRIEF DESCRIPTION OF THE DRAWINGS

Fig. 1 shows a schematic arrangement illustrating a sputtering apparatus employed in Example 1.
Fig. 2 shows a flow chart for a film formation method employed in Example 1.
Fig. 3 shows a schematic arrangement illustrating a sputtering apparatus employed in Example 3.
Fig. 4 shows a block diagram illustrating a control system of the sputtering apparatus shown in Fig. 3.
Fig. 5 shows a flow chart for a film formation method employed in Example 3.
Fig. 6 shows a schematic arrangement illustrating a sputtering apparatus employed in Example 5.
Fig. 7 shows a flow chart for a film formation method employed in Example 5.
Fig. 8 shows an example of modification of the sputtering apparatus shown in Fig. 6, illustrating an exemplary arrangement in which a substrate is installed to a rotatable substrate holder.
Fig. 9 shows another example of modification different from the example shown in Fig. 8, of the sputtering apparatus shown in Fig. 6, illustrating an exemplary arrangement in which first and second cathodes are arranged on a rotatable rotary stand.
Fig. 10 shows a schematic arrangement illustrating a sputtering apparatus employed in Example 7.
Fig. 11 shows a block diagram illustrating a control system of the sputtering apparatus shown in Fig. 10.
Fig. 12 shows a flow chart for a film formation method employed in Example 7.
Fig. 13 shows an example of modification of the sputtering apparatus shown in Fig. 6, illustrating an exemplary arrangement in which a sputtering apparatus is provided with a helicon coil.
Fig. 14 shows a basic arrangement of an exposure apparatus according to the present invention.
Fig. 15 shows a schematic arrangement of a conventional sputtering apparatus.

### BEST MODE FOR CARRYING OUT THE INVENTION

The film formation method and the sputtering apparatus according to the present invention will be explained in detail below with reference to Examples.

### Example 1

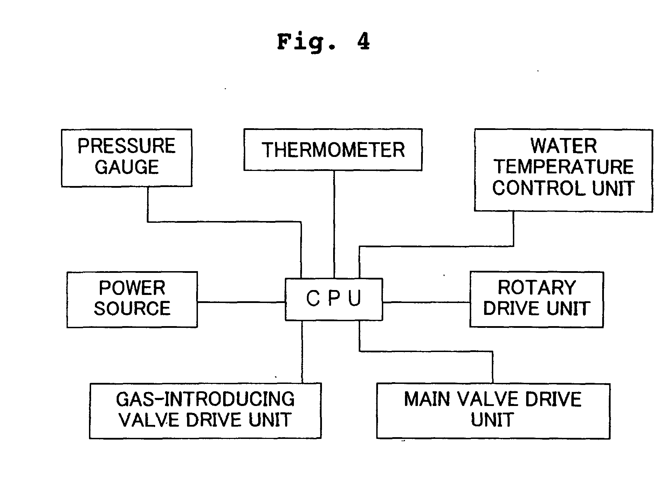

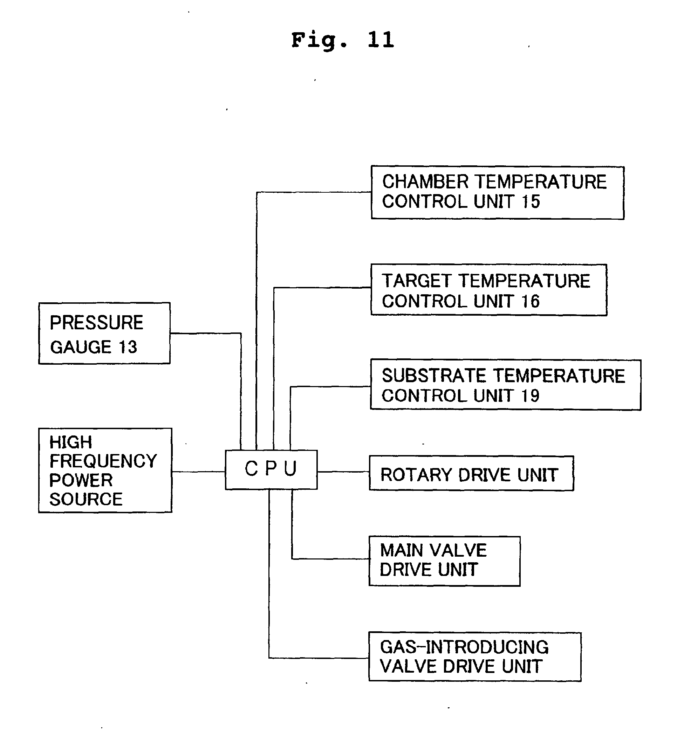

A schematic arrangement of a sputtering apparatus according to the present invention is shown in Fig. 1. The sputtering apparatus 100 principally comprises a vacuum chamber 1 for performing the film formation process, a vacuum pump 5 for evacuating the gas from the vacuum chamber 1, a gas tank 8 for introducing the sputtering gas into the vacuum chamber 1, and a control system 130. A main valve 4 is provided between the vacuum chamber 1 and the vacuum pump 5. The main valve 4 is driven and opened/closed by a main valve drive unit (not shown). A gas-introducing valve 9 is provided between the vacuum chamber 1 and the gas tank 8. The gas-introducing valve 9 is driven and opened/closed by a gas-introducing valve drive unit (not shown). The gas-introducing valve drive unit and the main valve drive unit are controlled by CPU (see Figs. 4 and 11) included in the control system 130. The flow rate of the sputtering gas 7 supplied to the vacuum chamber 1 is adjusted by a mass flow controller 6.

In the vacuum chamber 1, a magnetron cathode 30 is provided at a bottom portion, a substrate 2 is provided at an upper portion, and a shutter 10 is provided therebetween. An SiN target, which is a compound material to serve as a sputtering target 3, is placed on the magnetron cathode 30. The shutter 10 is rotatable about the center of the rotary shaft 11. The rotary shaft 11 is driven by a rotary shaft drive unit (not shown). The rotary shaft drive unit is controlled by CPU in the control system 130. A vacuum gauge 13 is provided in the vacuum chamber 1 in order to measure the internal gas pressure. Further a high frequency (RF) power source 31, which serves as a power source necessary for the electric discharge of the cathode, is connected to the magnetron cathode 30. The power source 31 is controlled by CPU in the control system 130. A glass substrate was used for the substrate 2.

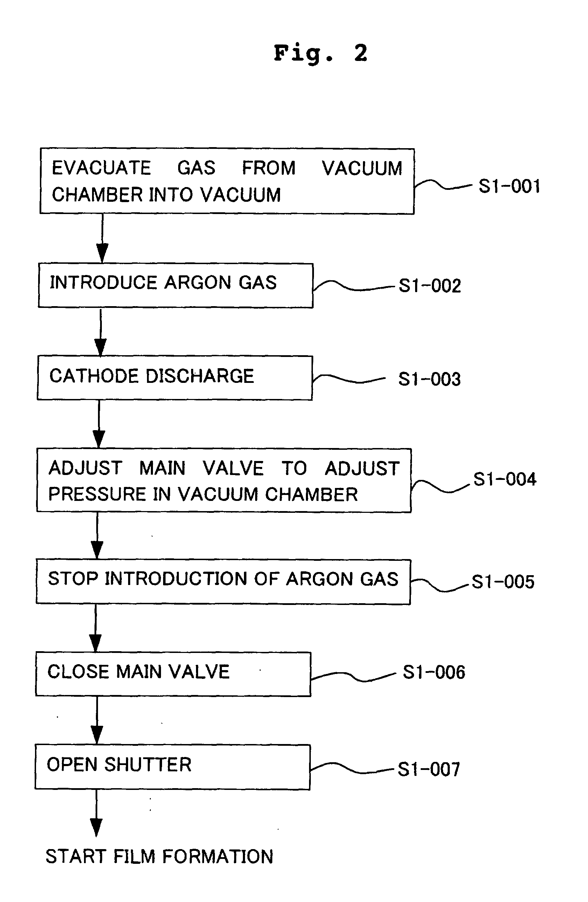

Explanation will be made with reference to Figs. 1 and 2 for a method for forming an SiN thin film on the substrate 2 by using the sputtering apparatus 100 as described above. Fig. 2 shows a flow chart illustrating the film formation method of the present invention.

At first, the main valve 4 is opened to start up the vacuum pump 5 in order to obtain a vacuum state in which the gas pressure in the vacuum chamber 1 is not more than 1 x 10⁻ ⁶ Torr (Step S1-001).

Subsequently, the gas-introducing valve 9 is opened to introduce the argon gas 7 into the vacuum chamber 1 while controlling the gas flow rate by using the mass flow controller 6 (Step S1-002).

Subsequently, the electric power (100 W) is supplied from the RF power source 31 to the magnetron cathode 30 to effect the cathode discharge for the SiN target 2 placed on the magnetron cathode 30 (Step S1-003).

Subsequently, the main valve 4 is adjusted to control the gas pressure in the vacuum chamber 1 to be 1 x 10⁻³ Torr (Step S1-004).

The gas-introducing valve 9 is closed to stop the introduction of the argon gas 7 into the vacuum chamber 1 (Step S1-005).

The main valve 4 is closed (Step S1-006). At this time, the gas pressure in the vacuum chamber 1 was 1 x 10⁻² Torr. Subsequently, the shutter 10, which is provided over the sputtering target 3 of SiN, is opened (Step S1-007) to start the film formation on the substrate 2.

An SiN film was formed to have a film thickness of about 50 nm on the substrate 2 in accordance with the film formation method as described above. The transmittance of the formed SiN film was measured. As a result, the transmittance was about 90 % with respect to a light beam having a wavelength of 633 nm.

### Example 2

In Example 2, an MgF₂ thin film was formed on a glass substrate by using the same film formation method as that used in Example 1 except that the sputtering target material was changed to MgF₂. The obtained MgF₂ thin film had a transmittance of about 90 % with respect to a light beam having a wavelength of 193 nm.

### Comparative Example 1

In Comparative Example 1, an SiN film was formed to have a film thickness of about 50 nm on a glass substrate by effecting the cathode discharge for an SiN target while reducing the pressure with the vacuum pump without tightly closing the vacuum chamber during the film formation. The transmittance of the obtained thin film was measured for the light beam having the wavelength of 633 nm. As a result, the transmittance was not more than 50 %.

### Comparative Example 2

In Comparative Example 2, an MgF₂ film was formed to have a film thickness of about 50 nm on a glass substrate in the same manner as in Comparative Example 1 except that MgF₂ was used for the target material. The obtained MgF₂ film had a transmittance of not more than 50 % with respect to the light beam having the wavelength of 193 nm.

### Example 3

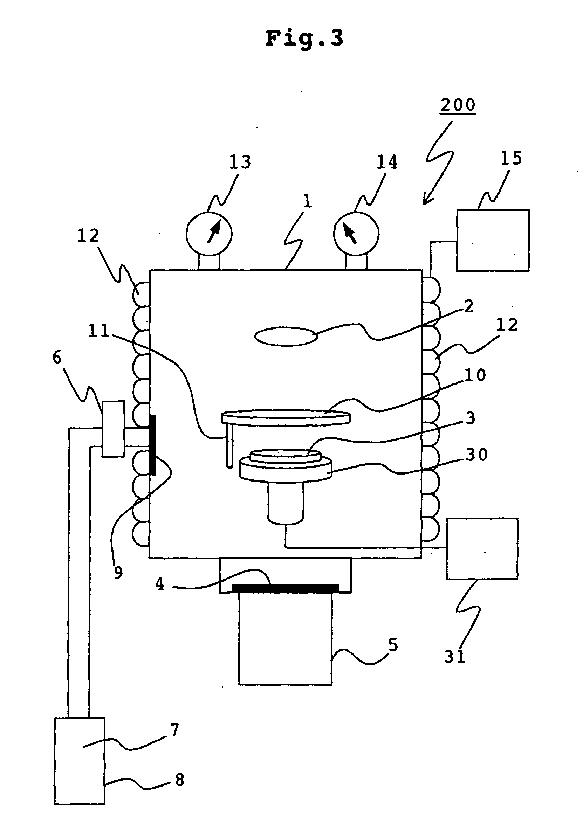

Explanation will be made on the basis of Figs. 3 and 4 for another exemplary arrangement of the sputtering apparatus according to the present invention and a film formation method based on the same. Fig. 3 shows a schematic arrangement of the sputtering apparatus of the present invention. Fig. 4 shows a block diagram illustrating a control system of the sputtering apparatus of the present invention.

With reference to Fig. 3, the sputtering apparatus 200 principally comprises a vacuum chamber 1 for performing the film formation process, a vacuum pump 5 for discharging the gas from the vacuum chamber 1, a gas tank 8 for introducing the sputtering gas into the vacuum chamber 1, a vacuum gauge 13 for measuring the pressure in the vacuum chamber 1, and a thermometer 14 for measuring the temperature in the vacuum chamber 1. A main valve 4 is provided between the vacuum chamber 1 and the vacuum pump 5. A gas-introducing valve 9 is provided between the vacuum chamber 1 and the gas tank 8. The main valve 4 is opened/closed by being driven by a main valve drive unit shown in Fig. 4. The gas-introducing valve 9 is opened/closed by being driven by a gas-introducing valve drive unit. As shown in Fig. 4, the gas-introducing valve drive unit and the main valve drive unit are controlled by CPU. The flow rate of the sputtering gas 7 supplied to the vacuum chamber 1 is adjusted by a mass flow controller 6.

A tube 12, through which the cooling water for regulating the temperature of the vacuum chamber passes, is provided on the outer wall portion of the vacuum chamber 1. The tube 12 is controlled to a water temperature control unit (temperature-regulating fluid supply unit) 15. The water temperature control unit 15 is provided with a water temperature-measuring section for measuring the temperature of the cooling water, and a water temperature-regulating section for regulating the water temperature. As shown in Fig. 4, the water temperature control unit 15 is controlled by CPU. As shown in Fig. 4, a measured value obtained by the pressure gauge 13 and a measured value obtained by the thermometer 14 are inputted into CPU. CPU performs calculation processing to determine the temperature at which the interior of the vacuum chamber 1 has a predetermined pressure. CPU sends a command to the water temperature control unit 15 so that the temperature, which is determined by the calculation processing, is obtained. The water temperature control unit 15 receives the command, and it regulates the water temperature of the cooling water so that the predetermined temperature is obtained.

A magnetron cathode 30, a substrate 2, and a shutter 10 are provided in the vacuum chamber 1 such that they are arranged in the same manner as in Fig. 1 respectively. An SiN target, which is a compound material to serve as a sputtering target 3, is placed on the magnetron cathode 30. The shutter 10 is rotatable about the center of a rotary shaft 11. The rotary shaft 11 is driven by a rotary shaft drive unit shown in Fig. 4. The rotary shaft drive unit is controlled by CPU. Further, a high frequency (RF) power source 31, which serves as a power source necessary for the electric discharge of the cathode, is connected to the magnetron cathode 30. As shown in Fig. 4, the power source is controlled by CPU. In Example 3, a glass substrate was used for the substrate 2.

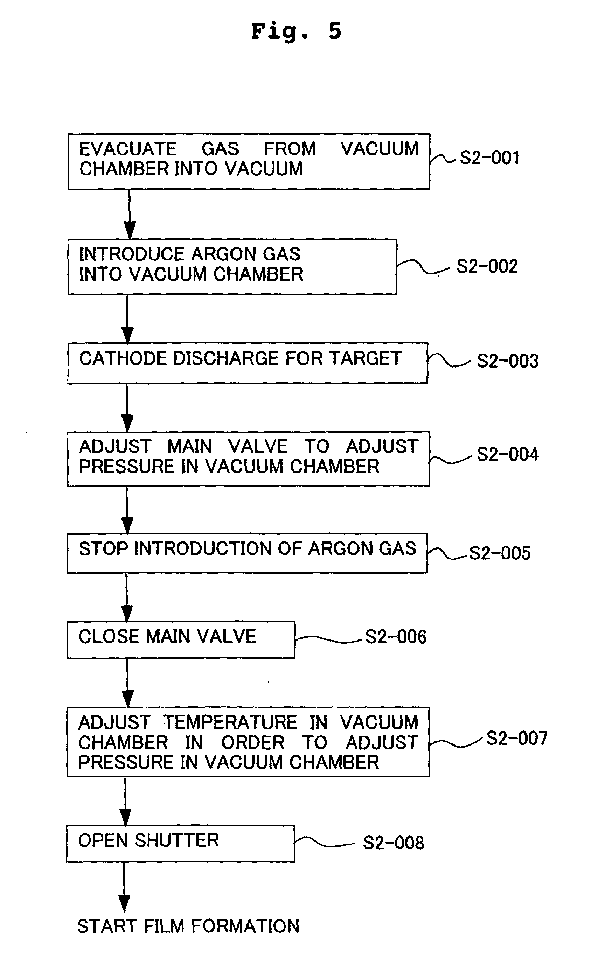

Next, explanation will be made with reference to Figs. 4 and 5 for a method for forming a film with the target material of SiN. Fig. 5 shows a flow chart illustrating an example of the film formation method of the present invention.

At first, the main valve 4 is opened to start up the vacuum pump 5 in order to obtain a vacuum state in which the gas pressure in the vacuum chamber 1 is not more than 1 x 10⁻ ⁶ Torr (Step S2-001).

The gas-introducing valve 9 is opened to introduce the argon gas 7 into the vacuum chamber 1 (Step S2-002).

The electric power (100 W) is supplied from the power source 31 to the magnetron cathode to effect the cathode discharge for the SiN target (Step S2-003).

The main valve 4 is adjusted to control the gas pressure in the vacuum chamber 1 to be 1 x 10⁻³ Torr (Step S2-004).

The gas-introducing valve 9 is closed to stop the introduction of the argon gas 7 into the vacuum chamber 1 (Step S2-005). Subsequently, the main valve 4 is closed (Step S2-006).

The temperature in the vacuum chamber 1 is controlled in order to obtain a constant gas pressure in the vacuum chamber 1 (Step S2-007). When the temperature in the vacuum chamber 1 is controlled, the water temperature of water to flow through the tube 12 is adjusted by using CPU and the water temperature control unit 15 so that the gas pressure in the vacuum chamber 1 is not less than 5 x 10⁻³ Torr, while monitoring the gas pressure and the temperature in the vacuum chamber by using the vacuum gauge 13 and the thermometer 14.

The shutter 10, which is provided over the sputtering target 3 of SiN, is opened (Step S2-008) to start the film formation on the substrate 2.

An SiN film was formed to have a film thickness of 50 nm on the glass substrate in accordance with the film formation method as described above. The transmittance of the obtained SiN film was measured with respect to a light beam having a wavelength of 633 nm. As a result, the transmittance was about 90.5 %. The transmittance possessed by the SiN film was higher than that of the SiN film formed in Example 1.

### Example 4

In Example 4, an MgF₂ thin film was formed on a glass substrate by using the same film formation method as that used in Example 3 except that the sputtering target material was changed to MgF₂. The obtained MgF₂ thin film had a transmittance of 90.5 % with respect to a light beam having a wavelength of 193 nm. The MgF₂ thin film had the transmittance higher than that of the MgF₂ film formed in Example 2.

### Example 5

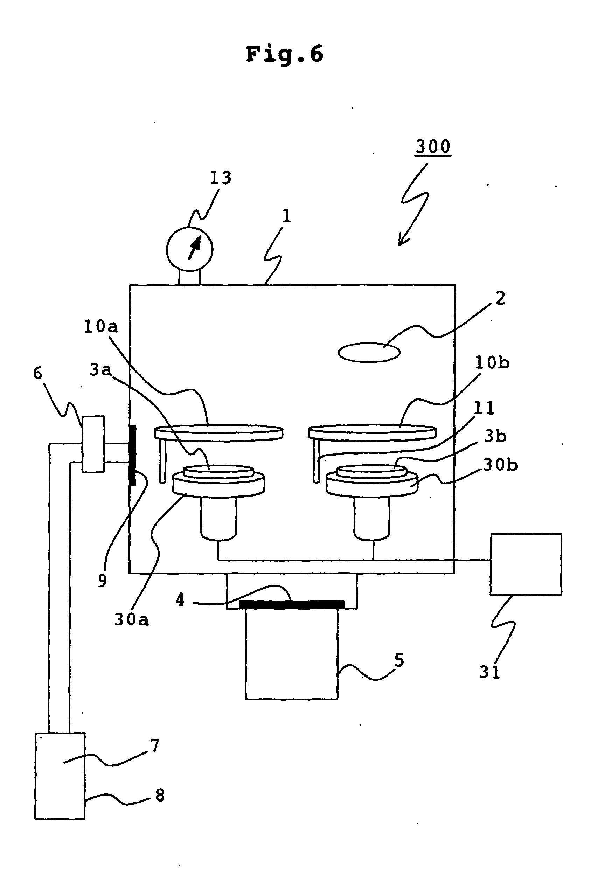

A schematic arrangement of a sputtering apparatus of Example 5 is shown in Fig. 6. With reference to Fig. 6, the sputtering apparatus 300 principally comprises a vacuum chamber 1 for performing the film formation process, a vacuum pump 5 for discharging the gas from the interior of the vacuum chamber 1, and a gas tank 8 for introducing the sputtering gas into the vacuum chamber 1. A main valve 4 is provided between the vacuum chamber 1 and the vacuum pump 5. The main valve 4 is opened/closed by being driven by a main valve drive unit (not shown). A gas-introducing valve 9 is provided between the vacuum chamber 1 and the gas tank 8. The gas-introducing valve 9 is opened/closed by being driven by a gas-introducing valve drive unit (not shown). The gas-introducing valve drive unit and the main valve drive unit are controlled by CPU (not shown). The flow rate of the sputtering gas 7 supplied to the vacuum chamber 1 is adjusted by a mass flow controller 6.

Two magnetron cathodes, i.e., a (preliminary) magnetron cathode 30a for enriching the gas component and a (main) magnetron cathode 30b for the film formation are provided in the vacuum chamber 1. An SiN target, which is a compound material to serve as a sputtering target 3a for enriching the gas component, is placed on the gas component-enriching medical care 30a. An SiN target, which is a compound material to serve as a sputtering target 3b for the film formation, is placed on the film-forming magnetron cathode 30b. A fixed shutter (unopenable shutter) 10a is provided over the gas component-enriching sputtering target 3a. On the other hand, a shutter 10b, which is rotatable about the center of a rotary shaft 11, is provided over the film-forming sputtering target 3b. The rotary shaft 11 is driven and rotated by a rotary shaft drive unit (not shown). The rotary shaft drive unit is controlled by CPU. A pressure gauge 13 is provided in order to measure the gas pressure in the vacuum chamber 1. Further, a high frequency (RF) power source 31, which serves as a power source necessary for the electric discharge, is connected to the gas component-enriching magnetron cathode 30a and the film-forming magnetron cathode 30b. The power source 31 is controlled by CPU. A glass substrate was used for the substrate 2.

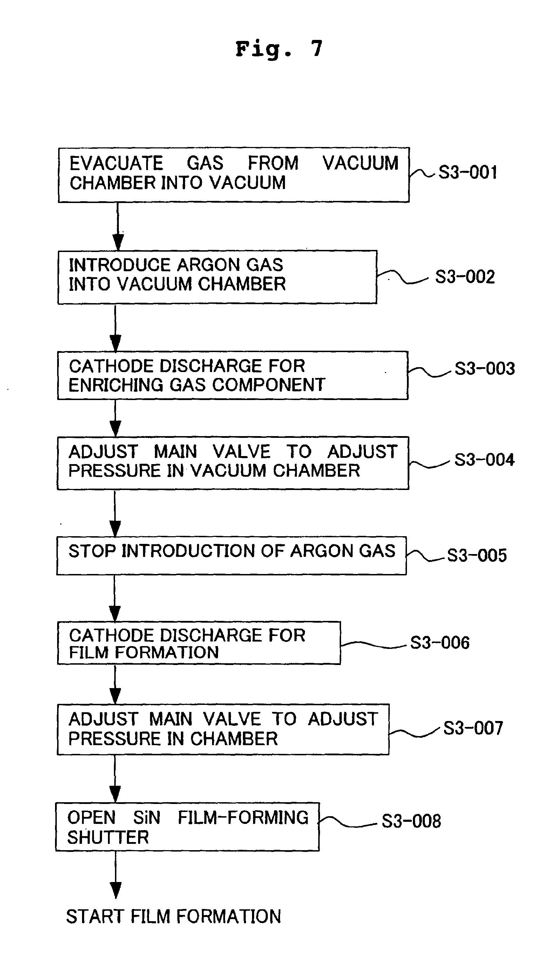

Next, explanation will be made with reference to Figs. 6 and 7 for a film formation method for forming a film by using the SiN target. Fig. 7 shows a flow chart illustrating an example of the film formation method of the present invention.

The main valve 4 is opened to start up the vacuum pump 5 in order to obtain a vacuum state in which the gas pressure in the vacuum chamber 1 is not more than 1 x 10⁻⁶ Torr (Step S3-001).

The gas-introducing valve 9 is opened to introduce the argon gas 7 into the vacuum chamber 1 (Step S3-002).

The high frequency electric power (RF power) is supplied from the power source 31 to the gas component-enriching magnetron cathode 30a to effect the cathode discharge for the gas component-enriching sputtering target 3a composed of SiN (Step S3-003). The RF power applied in this procedure was 250 W.

The main valve 4 is adjusted to control the gas pressure in the vacuum chamber 1 to be 1 x 10⁻³ Torr (Step S3-004).

The gas-introducing valve 9 is closed to stop the introduction of the argon gas 7 into the vacuum chamber 1 (Step S3-005).

The main valve 4 is adjusted to control the gas pressure in the vacuum chamber 1 to be 1 x 10⁻² Torr (Step S3-006).

The high frequency electric power (RF power) is supplied from the power source 31 to the film-forming magnetron cathode 30b to effect the cathode discharge for the film-forming sputtering target 3b composed of SiN (Step S3-007). The RF power applied in this procedure was 150 W.

The shutter 10b, which is provided over the SiN film-forming sputtering target 3b, is opened, and the shutter 10a, which is provided over the gas component-enriching sputtering target 3a, is allowed to remain closed (Step S3-008). Subsequently, the film formation was started on the substrate 2.

An SiN film was formed to have a film thickness of 50 nm on the substrate in accordance with the film formation method as described above. The transmittance of the obtained SiN film was measured with respect to a light beam having a wavelength of 633 nm. As a result, the transmittance was 92 %.

### Example 6

In Example 6, an MgF₂ thin film was formed on a glass substrate by using the same film formation method as that used in Example 5 except that the sputtering target material was changed to MgF₂. The obtained MgF₂ thin film had a transmittance of 92 % with respect to a light beam having a wavelength of 193 nm.

### Example 7

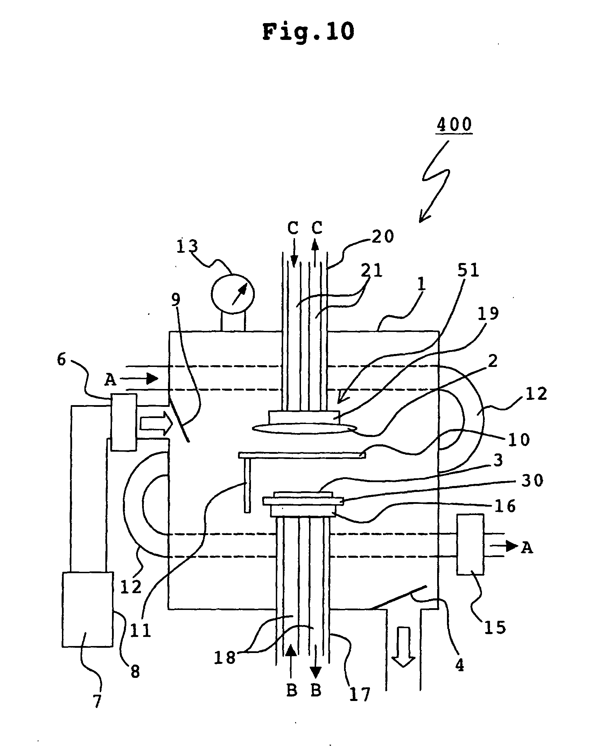

A sputtering apparatus of Example 7 will be explained with reference to Figs. 10 and 11. Fig. 10 shows a schematic arrangement of the sputtering apparatus, and Fig. 11 shows a block diagram illustrating a control system of the sputtering apparatus.

The sputtering apparatus 400 principally comprises a vacuum chamber 1 for performing the film formation process, a vacuum pump 5 for discharging the gas from the interior of the vacuum chamber 1, a gas tank 8 for introducing the sputtering gas into the vacuum chamber 1, and a pressure gauge 13 for measuring the pressure in the vacuum chamber 1. A main valve 4 is provided between the vacuum chamber 1 and the vacuum pump 5. A gas-introducing valve 9 is provided between the vacuum chamber 1 and the gas tank 8. The main valve 4 is opened/closed by being driven by a main valve drive unit shown in Fig. 11. The gas-introducing valve 9 is opened/closed by being driven by a gas-introducing valve drive unit. As shown in Fig. 11, the gas-introducing valve drive unit and the main valve drive unit are controlled by CPU. The flow rate of the sputtering gas 7 supplied to the vacuum chamber 1 is adjusted by a mass flow controller 6.

As shown in Fig. 10, a tube 12, through which the cooling water passes, is provided around the outer circumference of the vacuum chamber 1. The cooling water flows through the interior of the tube 12 in the direction of the arrow A. The tube 12 is connected to a chamber temperature control unit 15 which is composed of a water temperature-measuring section for measuring the temperature of water and a water temperature-regulating section for regulating the water temperature. As shown in Fig. 11, the chamber temperature control unit 15 is controlled by CPU. The water temperature-regulating section may be composed of a heater or the like, in the same manner as in Example 3 described above. The data on the water temperature measured by the water temperature-measuring section is inputted into CPU. CPU sends a command to the water temperature-regulating section so that a preset water temperature is obtained. The temperature in the chamber can be controlled to be the preset temperature (25 °C) by regulating the water temperature. The measured value measured by the pressure gauge 13 is inputted into CPU.

A magnetron cathode 30, a shutter 10, and a substrate 2 are provided in the vacuum chamber 1. The magnetron cathode has a placing stand for placing the sputtering target thereon, and a placing cylinder 17 for supporting the placing stand. The interior of the placing cylinder 17 is hollow, in which tubes for the inflow/outflow of the cooling water are provided respectively. The cooling water flows in the direction of the arrow B. The magnetron cathode 30 is provided with a target temperature control unit 16 for controlling the temperature of the sputtering target 3. The target temperature control unit 16 includes a water temperature-measuring section for measuring the temperature of the cooling water, and a water temperature-regulating section (heater) for regulating the water temperature of the cooling water, which is controlled by CPU. The method for controlling the water temperature is the same as that for the chamber temperature control unit, which is omitted from the description. The temperature of the target can be controlled to be a preset temperature (30 °C) by regulating the water temperature by using the target temperature control unit.

A high frequency (RF) power source (not shown), which serves as a power source necessary for the electric discharge, is connected to the magnetron cathode. As shown in Fig. 11, the high frequency power source is controlled by CPU.

As shown in Fig. 10, the substrate 2 is held by a substrate-holding member 51 which is provided with a substrate temperature control unit 19. A quartz optical lens was used for the substrate 2. The interior of a holding cylinder 20 for supporting the substrate-holding member 51 is hollow, in which tubes 21 for the inflow/outflow of the cooling water in the direction of the arrow C are arranged respectively. The substrate temperature control unit 19 includes a water temperature-measuring section for measuring the temperature of water, and a water temperature-regulating section for regulating the water temperature, which is controlled by CPU as shown in Fig. 11. The method for controlling the water temperature is the same as that for the vacuum chamber control unit, which is omitted from the description. The temperature of the substrate can be controlled to be a preset temperature (15 °C) by regulating the water temperature by using the substrate temperature control unit 19.

The sputtering apparatus 400 is constructed such that the cooling water is circulated through the tubes 12, 18, 21 respectively. The cooling water is supplied from an unillustrated common supply source. With reference to Fig. 11, CPU sends commands to the chamber temperature control unit 15, the target temperature control unit 16, and the substrate temperature control unit 19 so that the preset temperatures are obtained. When the commands are received, the chamber temperature control unit 15, the target temperature control unit 16, and the substrate temperature control unit 19 can regulate the water temperature so that the temperatures are obtained respectively as described above.

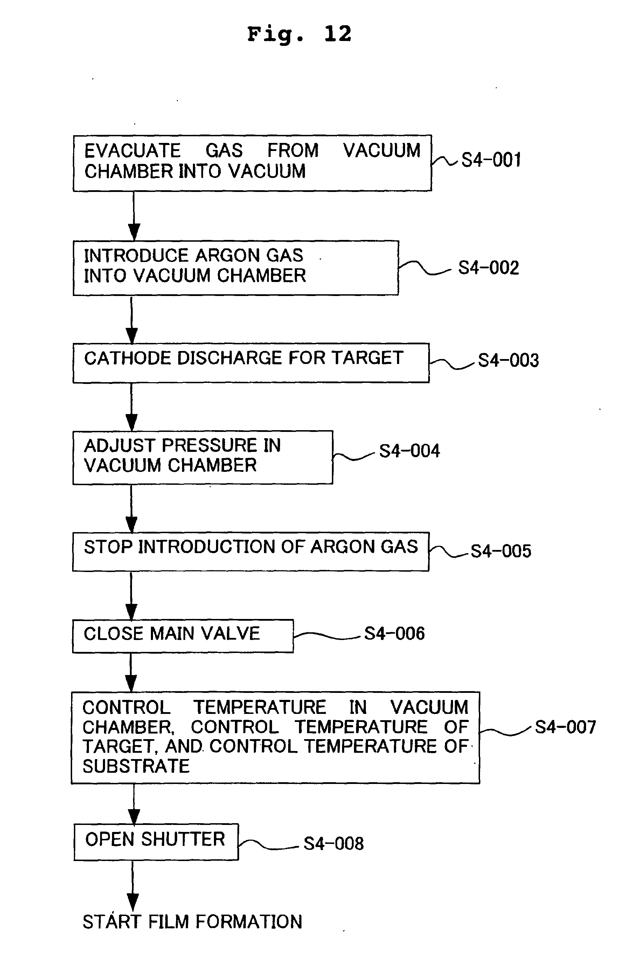

Next, explanation will be made with reference to Figs. 10 and 12 for a method for forming a film of SiN on a glass substrate by using the sputtering apparatus as described above. Fig. 12 shows a flow chart illustrating an example of the film formation method of the present invention.

The main valve 4 is opened to start up the vacuum pump in order to obtain a vacuum state in which the gas pressure in the vacuum chamber 1 is not more than 1 x 10⁻⁶ Torr (Step S4-001).

The gas-introducing valve 9 is opened to introduce the argon gas 7 into the vacuum chamber 1 (Step S4-002).

The high frequency electric power (RF power) is supplied from the high frequency power source to the magnetron cathode to effect the cathode discharge for the SiN target (Step S4-003). In this procedure, the applied RF power was 100 W.

The main valve 4 is adjusted to control the gas pressure in the vacuum chamber 1 to be 1 x 10⁻³ Torr (Step S4-004).

The gas-introducing valve 9 is closed to stop the introduction of the argon gas 7 into the vacuum chamber 1 (Step S4-005). Subsequently, the main valve 4 is closed (Step S4-006).

The temperature in the vacuum chamber 1, the temperature of the target, and the temperature of the substrate are controlled to be 25 °C, 30 °C, and 15 °C respectively (Step S4-007). In this procedure, the gas pressure in the vacuum chamber 1 is controlled to be not less than 5 x 10⁻³ Torr.

The shutter 10, which is provided over the sputtering target 3 of SiN, is opened (Step S4-008) to start the film formation on the substrate 2.

An SiN film was formed to have a film thickness of about 50 nm on the quartz optical lens in accordance with the film formation method as described above. The transmittance of the obtained SiN film was 91 % with respect to a light beam having a wavelength of 633 nm.

In Example 7, the temperature control is performed after closing the main valve. However, the temperature control can be performed at arbitrary timing before starting the film formation.

### Example 8

In Example 8, an MgF₂ thin film was formed on a quartz optical lens by using the same film formation method as that used in Example 7 except that the sputtering target material was changed to MgF₂. The obtained MgF₂ thin film had a transmittance of 91 % with respect to a light beam having a wavelength of 193 nm.

### Example of Modification

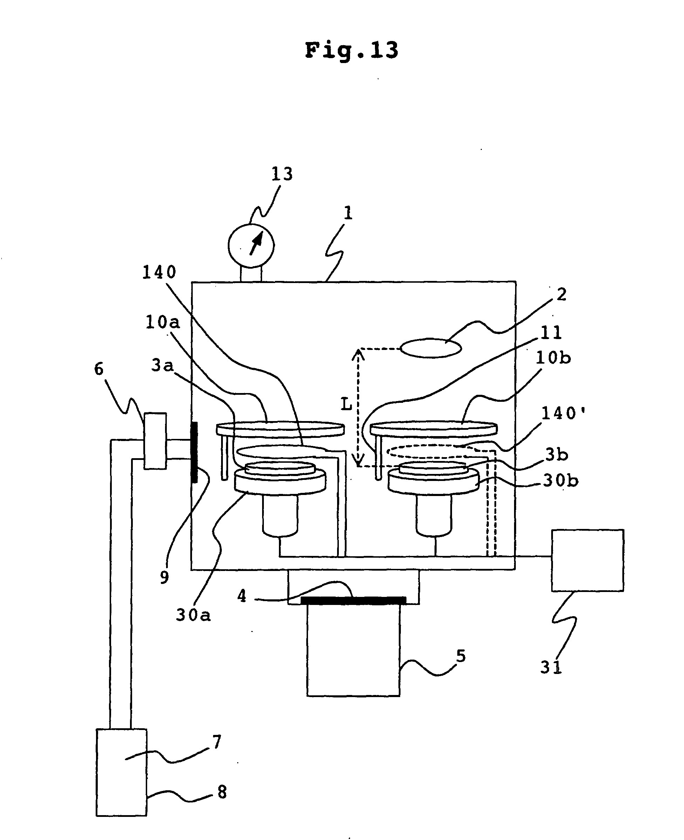

Fig. 13 shows an example of modification of the sputtering apparatus shown in Example 5. The sputtering apparatus 400 shown in Fig. 13 is a sputtering apparatus for the helicon sputtering. A helicon coil 140 for the helicon sputtering is inserted between the fixed shutter 10a and the gas component-enriching target 3a. The other respective portions are the same as those of the sputtering apparatus of Example 5 (see Fig. 6), explanation of which will be omitted. The high frequency electric power having a predetermined frequency is supplied to the helicon coil 140 during the film formation.

The helicon sputtering was performed while supplying the RF electric power having a frequency of 13 Hz to the helicon coil 140 by using the sputtering apparatus 400 as described above to form an SiN film having a film thickness of 50 nm on a glass substrate 2. The transmittance of the obtained SiN film was 92.2 % with respect to a light beam having a wavelength of 633 nm. The surface of the SiN film was observed with an atomic force microscope to investigate the surface state. As a result, it was revealed that the SiN film was an extremely uniform film.

In another procedure, a glass substrate 2 was arranged to be farther from the film-forming target so that the distance L between the film-forming target 3b and the glass substrate 2 was 15 cm to 25 cm. An SiN film was formed on the glass substrate by performing the helicon sputtering in the same manner as described above. The transmittance of the obtained SiN film was 92.4 % with respect to the light beam having the wavelength of 633 nm.

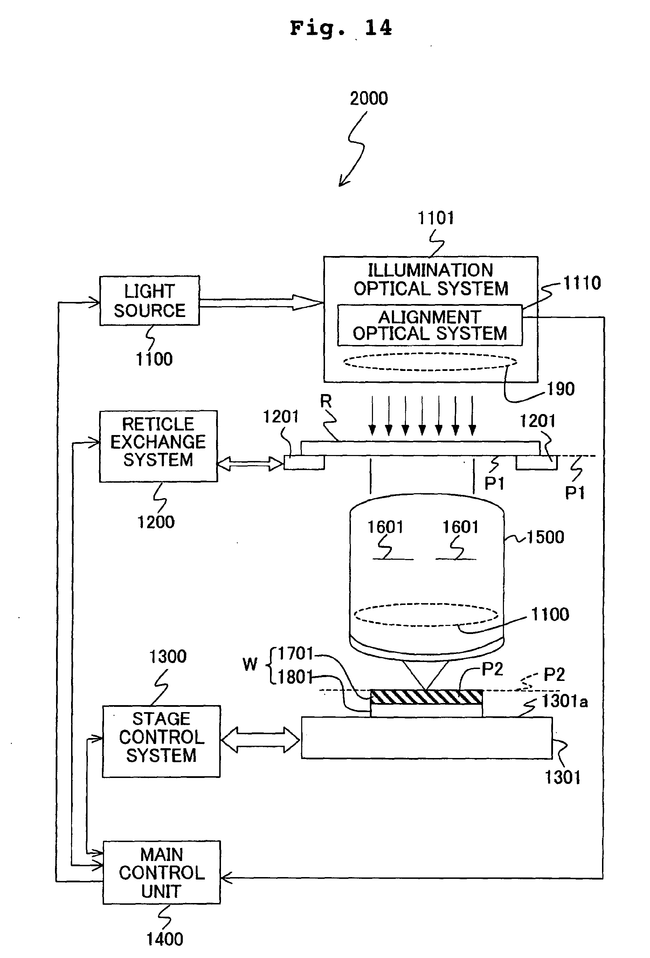

In this example of modification, the helicon coil 140 is provided only at the position just over the gas component-enriching target 3a. However, as indicated by reference numeral 140' in Fig. 14, a helicon coil may be also provided just over the film-forming target 3, and both of the gas component-enriching target and the film-forming target may be subjected to the helicon sputtering.

### Example of Application to Exposure Apparatus

Next, explanation will be made with reference to Fig. 14 for a case in which an optical element provided with the thin film formed by the film formation method of the present invention is used for an exposure apparatus. Fig. 14 conceptually shows a scanning type projection exposure apparatus 2000 for exposing a wafer 1801 coated with a photoresist 1701 (W as a whole) with an image of a pattern on a reticle R. The optical elements produced in Examples 1 to 8 are applicable to the exposure apparatus.

As shown in Fig. 14, the projection exposure apparatus of the present invention comprises at least a reticle stage 1201 which is movable in the direction parallel to the surface of the reticle R while holding the reticle R (mask), a wafer stage 1301 which is movable in the direction parallel to the wafer surface while holding the wafer (substrate) W on the surface 1301a, an illumination optical system 1101 which radiates the vacuum ultraviolet light beam onto the reticle R (mask), a light source 1100 which supplies the vacuum ultraviolet light beam as an exposure light beam to the illumination optical system 1101, and a projection optical system 1500 which projects the image of the pattern on the reticle R onto the wafer W. The projection optical system 1500 is arranged between the reticle R and the wafer W so that the surface P1, on which the reticle R is arranged, is the object plane, and the surface P2 of the wafer W is the image plane. The illumination optical system 1101 includes an alignment optical system 1110 for adjusting the relative positions of the reticle R and the wafer W. A reticle exchange system 1200 exchanges and transports the reticle R set on the reticle stage 1201. The reticle exchange system 1200 includes a reticle stage driver (not shown) for moving the reticle stage 1201. A stage control system 1300 is provided with a wafer stage driver (not shown) for moving the wafer stage 1301. A main control system 1400 controls the reticle stage driver and the wafer stage driver by the aid of the stage control system 1300 to drive the reticle stage and the wafer stage so that the reticle stage and the wafer stage are moved in synchronization with the exposure light beam. The projection optical system 1500 further comprises an alignment optical system 1601.

The optical element, which is coated with the MgF₂ film produced in Example described above, can be used for the exposure apparatus 2000. Specifically, the optical element, which was produced in each of Examples 1 to 8, can be used for the optical lens 190 of the illumination optical system 1101 and the projection lens 1100 of the projection optical system 1500. Usually, a plurality of projection lenses 1100 are arranged in the projection optical system 1500. Especially, it is preferable that the lens according to the present invention is used for the lens which is disposed on the light-outgoing side, i.e., at the position nearest to the wafer W. In this arrangement, the thin film may be applied to only the light-incoming surface of the projection lens. Alternatively, the thin film may be applied to the entire lens. Further, those used as the optical elements in the exposure apparatus include, for example, fly's eye lenses, a variety of relay lenses, beam splitters, condenser lenses, beam expanders, and reflecting mirrors. However, the present invention is applicable to any one of the elements.

Fig. 14 is illustrative of the scanning type projection exposure apparatus. However, there is no limitation thereto. The present invention is also applicable to the projection exposure apparatus based on the step-and-repeat system (so-called stepper), the mirror projection aligner, and the proximity type exposure apparatus. The projection exposure apparatus and the optical elements used for the same are disclosed in United States Patent No. 5,835,275, a content of which is incorporated herein by reference so long as the domestic laws and ordinances of the designated state permit the incorporation.

Further, the optical element of the present invention is usable for a variety of apparatuses other than the exposure apparatus, including, for example, spectroscopes, laser repair apparatuses, various inspection apparatuses, and sensors.

In Examples 1 to 8 described above, the thin film is formed on the glass substrate or the quartz optical lens. However, there is no limitation thereto. The thin film can be formed on any one of optical elements including, for example, optical lenses, prisms, and reflecting mirrors made of quartz, plastic, or fluorite.

In Examples 1 to 8 described above, the single layer film is formed on the glass substrate. However, it is also possible to form a multilayered film.

### INDUSTRIAL APPLICABILITY

According to the film formation method of the present invention, the compound film containing the gaseous component element can be formed. Therefore, the film formation method of the present invention is most suitable as the coating method for the optical thin film on the optical element for which the high optical transmission is required. Especially, the film formation method of the present invention is useful for the coating method for the optical element having the high optical transmission with respect to the light beam having the short wavelength such as the vacuum ultraviolet light. Further, it is possible to enhance the hardness and the tight contact performance of the formed compound film as compared with the vapor deposition method, because the film is formed by means of the sputtering. Furthermore, it is unnecessary to replenish the reactive gas during the film formation. Therefore, it is unnecessary to provide any equipment for introducing the reactive gas, and the apparatus is cheap as well. The optical element, which is equipped with the compound film manufactured by the film formation method of the present invention, is excellent in light transmittance. Therefore, when the exposure apparatus provided with the optical element as described above is used, it is possible to reduce the loss of the illuminance of the light source as compared with the conventional exposure apparatus. Accordingly, it is possible to enhance the efficiency of utilization of light. Especially, the present invention is extremely effective on the exposure apparatus for producing VLSI (very-large-scale integration system) and the superresolution liquid crystal substrate for which the light source having the wavelength of not more than 200 nm is used.

## Claims

1. A film formation method by sputtering, comprising arranging a sputtering target composed of a compound material and a film formation objective substrate in a vacuum chamber, supplying a sputtering gas to the vacuum chamber, and then performing the sputtering in a state in which the vacuum chamber is tightly closed.

2. The film formation method according to claim 1, wherein the compound material is a material selected from the group consisting of oxide, nitride, and fluoride.

3. The film formation method according to claim 1, wherein a gas, which is selected from the group consisting of Ar gas, Xe gas, He gas, SF₆ gas, and mixed gas of Ar and SF₆, is used for the sputtering gas.

4. The film formation method according to claim 1, wherein a distance between the target and the substrate is 15 cm to 25 cm.

5. The film formation method according to claim 1, wherein helicon sputtering is used for the sputtering.

6. The film formation method according to claim 1, further comprising a step of controlling internal pressure of the vacuum chamber.

7. The film formation method according to claim 1, further comprising a step of controlling temperature of the substrate during the sputtering.

8. The film formation method according to claim 1, further comprising stopping the supply of the sputtering gas after supplying the sputtering gas to the vacuum chamber, discharging the sputtering gas having been supplied into the vacuum chamber to adjust a pressure in the vacuum chamber to be a predetermined pressure, and then tightly closing the vacuum chamber.

9. A film formation method for forming a thin film on a substrate by sputtering a target in a vacuum chamber, the film formation method comprising:
using at least two targets of a first target and a second target;
placing a shield plate between the first target and the substrate; and
sputtering the first target and the second target.

10. The film formation method according to claim 9, wherein the first target and the second target are formed of a compound material containing a gaseous component element, respectively.

11. The film formation method according to claim 9, wherein a first electric power is applied to the first target to sputter the first target, and a second electric power, which is different from the first electric power, is applied to the second target to sputter the second target.

12. The film formation method according to claim 9, wherein the sputtering is performed while revolving the substrate so that the substrate alternately passes across positions just over the first target and the second target respectively.

13. The film formation method according to claim 10, wherein the compound material is one selected from the group consisting of oxide, nitride, and fluoride.

14. The film formation method according to claim 13, wherein the first target and the second target are formed of the compound materials which contain at least one common gaseous component element.

15. The film formation method according to claim 14, wherein the sputtering is firstly effected from the first target to the shield plate, and then the sputtering is effected from the second target to the substrate.

16. The film formation method according to claim 9, wherein a gas, which is selected from the group consisting of Ar gas, Xe gas, He gas, SF₆ gas, and mixed gas of Ar and SF₆, is used for a sputtering gas.

17. The film formation method according to claim 9, wherein a distance between the target and the substrate is 15 cm to 25 cm.

18. The film formation method according to claim 9, wherein helicon sputtering is used for the sputtering.

19. A film formation method for forming a thin film on a substrate by sputtering a target in a vacuum chamber, the film formation method comprising:
independently controlling temperatures of the substrate, the target, and interior of the vacuum chamber.

20. The film formation method according to claim 19, further comprising controlling at least one temperature of the temperature of the substrate and the temperature of the target so that the temperature of the substrate is lower than the temperature of the target.

21. The film formation method according to claim 19, further comprising controlling at least one temperature of the temperature of the substrate and the temperature of the interior of the vacuum chamber so that the temperature of the substrate is lower than the temperature of the interior of the vacuum chamber.

22. The film formation method according to claim 19, wherein a gas, which is selected from the group consisting of Ar gas, Xe gas, He gas, SF₆ gas, and mixed gas of Ar and SF₆, is used for a sputtering gas.

23. The film formation method according to claim 19, wherein a distance between the target and the substrate is 15 cm to 25 cm.

24. The film formation method according to claim 19, wherein helicon sputtering is used for the sputtering.

25. The film formation method according to claim 19, wherein the target is formed of a material selected from the group consisting of oxide, nitride, and fluoride.

26. A sputtering apparatus for forming a thin film on a substrate, the sputtering apparatus comprising:
a vacuum chamber;
a gas-introducing valve which is formed for the vacuum chamber and which is used to introduce a sputtering gas into the vacuum chamber;
a gas discharge valve which is formed for the vacuum chamber and which is used to discharge the sputtering gas from interior of the vacuum chamber; and
a control unit which controls the gas-introducing valve and the gas discharge valve to be closed during sputtering so that the vacuum chamber is tightly closed.

27. The sputtering apparatus according to claim 26, wherein a gas, which is selected from the group consisting of Ar gas, Xe gas, He gas, SF₆ gas, and mixed gas of Ar and SF₆, is used for the sputtering gas.

28. The sputtering apparatus according to claim 26, further comprising a target which is opposed to the substrate in the vacuum chamber, wherein a distance between the target and the substrate is 15 cm to 25 cm.

29. The sputtering apparatus according to claim 28, further comprising a coil which is disposed just over the target and which generates a helicon wave.

30. The sputtering apparatus according to claim 26, further comprising a pressure control unit which controls an internal pressure of the vacuum chamber.

31. The sputtering apparatus according to claim 26, wherein the pressure control unit is a temperature-adjusting unit which adjusts an internal temperature of the vacuum chamber.

32. A sputtering apparatus for forming a thin film on a substrate, comprising:
a vacuum chamber;
a first cathode electrode which is provided in the vacuum chamber and on which a first target is placed;
a second cathode electrode which is juxtaposed with the first cathode electrode in the vacuum chamber and on which a second target is placed;
a power source which supplies electric power to the first cathode electrode and the second cathode electrode; and
a shield plate which is positioned between the first cathode electrode and the substrate, wherein:
the electric power is supplied from the power source to the first cathode electrode and the second cathode electrode to perform sputtering while shielding the first cathode electrode with the shield plate.

33. The sputtering apparatus according to claim 32, further comprising a rotatable substrate holder which holds the substrate, wherein the substrate is installed to the substrate holder so that the substrate is eccentric with respect to an axis of rotation of the substrate holder.

34. The sputtering apparatus according to claim 32, wherein the substrate is installed so that the substrate is opposed to the second cathode electrode.

35. The sputtering apparatus according to claim 32, further comprising a rotary stand which rotates the first cathode electrode and the second cathode electrode with respect to the substrate.

36. The sputtering apparatus according to claim 32, wherein the electric power, which is supplied by the power source to the first cathode electrode, is different from the electric power which is supplied to the second cathode electrode.

37. The sputtering apparatus according to claim 32, further comprising a coil which is disposed over the first cathode electrode and which generates a helicon wave.

38. The sputtering apparatus according to claim 32, wherein each of a distance between the substrate and the first target placed on the first cathode electrode and a distance between the substrate and the second target placed on the second cathode electrode is within a range of 15 cm to 25 cm.

39. A sputtering apparatus for forming a thin film on a substrate, the sputtering apparatus comprising:
a vacuum chamber;
a cathode electrode which is arranged in the vacuum chamber and on which a target is placed;
a chamber temperature-regulating unit which regulates temperature in the vacuum chamber;
a target temperature-regulating unit which regulates temperature of the target; and
a substrate temperature-regulating unit which regulates temperature of the substrate.

40. The sputtering apparatus according to claim 39, further comprising a control unit which controls the chamber temperature-regulating unit, the target temperature-regulating unit, and the substrate temperature-regulating unit, wherein the control unit controls at least one of the vacuum chamber temperature-regulating unit and the substrate temperature-regulating unit so that the temperature of the substrate is lower than the temperature in the vacuum chamber.

41. The sputtering apparatus according to claim 40, wherein the control unit controls at least one of the target temperature-regulating unit and the substrate temperature-regulating unit so that the temperature of the substrate is lower than the temperature of the target.

42. The sputtering apparatus according to claim 39, wherein a distance between the target and the substrate is 15 cm to 25 cm.

43. The sputtering apparatus according to claim 39, further comprising a coil which is disposed just over the target and which generates a helicon wave.

44. The film formation method according to any one of claims 1, 9, and 19, wherein the substrate is an optical element selected from the group consisting of a lens, a prism, and a reflecting mirror.

45. An optical element having a thin film which is formed by the film formation method as defined in any one of claims 1, 9, and 19.

46. An exposure apparatus for exposing a substrate with an image of a pattern on a mask, the exposure apparatus comprising:
an illumination optical system which illuminates the mask with a vacuum ultraviolet light beam; and
a projection optical system which includes the optical element as defined in claim 45 and which projects the image of the pattern on the mask onto the substrate.

47. An exposure apparatus for exposing a substrate with an image of a pattern on a mask, the exposure apparatus comprising:
an illumination optical system which includes the optical element as defined in claim 45 and which illuminates the mask with a vacuum ultraviolet light beam; and
a projection optical system which projects the image of the pattern on the mask onto the substrate.

48. The exposure apparatus according to claim 47, further comprising a light source which radiates the light beam having a wavelength of not more than 200 nm.

49. The exposure apparatus according to claim 48, further comprising a light source which radiates the light beam having a wavelength of not more than 200 nm.
